# EUROPÄISCHE PATENTSCHRIFT

(11) **EP 2 149 163 B1**
(45) Veröffentlichungstag und Bekanntmachung des Hinweises auf die Patenterteilung: **12.04.2017**
(21) Anmeldenummer: 08758109.6
(22) Anmeldetag: 21.05.2008
(51) Int. Cl.: H01L 33/00

(54) **LUMINESZENZDIODENCHIP MIT WINKELFILTERELEMENT**
LUMINESCENCE DIODE CHIP WITH AN ANGLE FILTER ELEMENT
PUCE DE DIODE ÉLECTROLUMINESCENTE AVEC ÉLÉMENT D'ANGLE FILTRANT

(30) Priorität: 30.05.2007 DE 102007025092
(43) Veröffentlichungstag der Anmeldung: 03.02.2010
(73) Patentinhaber: OSRAM Opto Semiconductors GmbH, 93055 Regensburg (DE)
(72) Erfinder: STREUBEL, Klaus, 93164 Laaber (DE); WIRTH, Ralph, 93138 Lappersdorf (DE)
(74) Vertreter: Epping - Hermann - Fischer
(86) Internationale Anmeldenummer: PCT/DE2008/000869
(87) Internationale Veröffentlichungsnummer: WO 2008/145096

(56) Entgegenhaltungen:
- EP-A- 1 643 567
- WO-A-2006/035388
- WO-A-2008/040298
- US-A- 5 813 752
- US-A1- 2006 054 904
- US-A1- 2006 203 468
- US-A1- 2007 023 762
- US-A1- 2007 085 100

## Beschreibung

Die Erfindung betrifft einen Lumineszenzdiodenchip.

Mithilfe einer LED, die beispielsweise blaues Licht erzeugt und durch ein geeignetes Konvertermaterial einen Teil des blauen Lichts in gelbes Licht umwandelt, kann infolge der entstehenden Farbmischung des originären blauen Lichts mit dem konvertierten gelben Licht Weißlicht erzeugt werden. Ein dabei auftretendes Problem ist in der Offenlegungsschrift DE 199 18 370 A1 beschrieben. Aufgrund verschiedener Weglängen von Lichtstrahlen innerhalb einer die LED umgebenden Harzfüllung, in welcher das Konvertermaterial enthalten ist, kann im Randbereich eines Bauelements der gelbe Anteil in der Gesamtstrahlung überwiegen, während im Gegensatz dazu in der Mitte der blaue Anteil überwiegt. Gemäß der Offenlegungsschrift DE 199 18 370 A1 wird dieses Problem dadurch gelöst, dass durch eine entsprechende Gestalt der Harzfüllung, nämlich durch eine konvexe Oberfläche der Harzfüllung, eine einheitliche Weglänge der omnidirektional emittierten Lichtstrahlung geschaffen wird.

In der Druckschrift US 5,813,752 A ist ein LED mit einem Konversionselement und mit einem Bandpassfilter angegeben. Die Druckschrift US 2007/0023762 A1 betrifft eine weißes Lichte emittierende LED-Lampe.

Eine Leuchte mit einem Wellenlängenkonversionselement ist in der Druckschrift US 2006/0203468 A1 offenbart.

Eine Beschreibung einer Lichtauskoppelstruktur und einer Konversionsstruktur ist in der Druckschrift US 2007/0085100 A1 zu finden.

Es ist Aufgabe der vorliegenden Erfindung, einen Lumineszenzdiodenchip mit einheitlichem Farbort anzugeben.

Diese Aufgabe wird durch einen Lumineszenzdiodenchip gemäß Patentanspruch 1 gelöst.

Vorteilhafte Weiterbildungen des Lumineszenzdiodenchips sind in den abhängigen Ansprüchen angegeben.

Ein erfindungsgemäßer Lumineszenzdiodenchip umfasst einen Halbleiterkörper, der Strahlung einer ersten Wellenlänge erzeugt, sowie ein Lumineszenzkonversionselement, das aus der Strahlung erster Wellenlänge Strahlung einer zweiten Wellenlänge erzeugt, und ein Winkelfilterelement, das Strahlung, die in einem vorgegebenen Winkelbereich relativ zu einer Hauptabstrahlrichtung auf das Winkelfilterelement auftrifft, zumindest teilweise in Richtung des Halbleiterkörpers zurückreflektiert. Das Winkelfilterelement weist für Lichtstrahlen der ersten Wellenlänge für kleine Einfallswinkel, welche mit der Hauptabstrahlrichtung den Winkel -30° ≤ θ ≤ 30° einschließen, ein höheres Reflexionsvermögen und für größere Einfallswinkel, welche mit der Hauptabstrahlrichtung den Winkel 30° ≤ θ ≤ 60° oder -60° ≤ θ ≤ -30°einschließen, ein geringeres Reflexionsvermögen auf.

Vorteilhafterweise kann mittels des Lumineszenzdiodenchips eine mischfarbige Gesamtstrahlung, beispielsweise weißes Licht, erzeugt werden, die sich in geeigneten Anteilen aus Strahlung der ersten Wellenlänge und der zweiten Wellenlänge zusammensetzt derart, dass ein Betrachter einen durch die mischfarbige Gesamtstrahlung verursachten Farbeindruck sowohl von dem durch die Strahlung der ersten Wellenlänge verursachten Farbeindruck als auch von dem durch die Strahlung der zweiten Wellenlänge verursachten Farbeindruck unterscheiden kann.

Der vorgegebene Winkelbereich gibt insbesondere den Winkelbereich an, in dem ein spezieller Strahlungsanteil für einen Betrachter erkennbar wäre, wenn kein Winkelfilterelement verwendet würde. Alternativ wäre es auch denkbar, den vorgegebenen Winkelbereich als den Winkelbereich zu wählen, bei welchem ein spezieller Strahlungsanteil ohne das Winkelfilterelement für den Betrachter erkennbar unterrepräsentiert wäre. Die von dem Lumineszenzdiodenchip abgegebene Gesamtstrahlung weist insbesondere Strahlungsanteile der ersten Wellenlänge und der zweiten Wellenlänge auf. Vorzugsweise entsprechen die erste und die zweite Wellenlänge zwei verschiedenen Farben, die zueinander komplementär sind. Mit dem eingangs genannten Beispiel gesprochen gibt der vorgegebene Winkelbereich vorliegend den Winkelbereich an, bei welchem der Betrachter ohne Winkelfilterelement aufgrund eines höheren Blauanteils und geringeren Gelbanteils in der Gesamtstrahlung ein kälteres Weißlicht wahrnehmen würde. Vorzugsweise ist der vorgegebene Winkelbereich relativ zur Hauptabstrahlrichtung symmetrisch angeordnet.

Gemäß einer bevorzugten Variante wird ein Winkelfilterelement verwendet, das zumindest einen Teil der Strahlung der ersten Wellenlänge derart zurückreflektiert, dass eine von dem Lumineszenzdiodenchip abgegebene Gesamtstrahlung einen winkelunabhängigen einheitlichen Farbort aufweist. Dies kann unter anderem dadurch ermöglicht werden, dass mittels der Reflexion am Winkelfilterelement die Strahlung der ersten Wellenlänge, die aus dem Lumineszenzdiodenchip austritt, abgeschwächt wird.

Gemäß einer weiter bevorzugten Variante kann mittels des Winkelfilterelements Strahlung der ersten Wellenlänge in Richtung des Halbleiterkörpers zurückreflektiert werden. Mit Vorteil wird die zurückreflektierte Strahlung im Halbleiterkörper absorbiert und wieder emittiert, was als "Photonrecycling" bezeichnet wird. Die zurückreflektierte Strahlung geht also nicht verloren, sondern kann nach erneuter Emission aus dem Halbleiterkörper austreten, wenn sie unter einem anderen Winkel auf das Winkelfilterelement auftrifft. Vorteilhaft sind hierbei die Winkel, bei welchen das Verhältnis zwischen der Strahlung der ersten Wellenlänge und der Strahlung der zweiten Wellenlänge ausgewogen ist, so dass die vom Bauelement abgegebene Gesamtstrahlung den gewünschten Farbort aufweist. Mittels des Winkelfilterelements wird ein Abstrahlprofil des Lumineszenzdiodenchips vorzugsweise derart verändert, dass eine Strahlungsintensität in dem vorgegebenen Winkelbereich reduziert und den anderen Winkeln erhöht ist.

Eine mögliche Anordnung des Winkelfilterelements besteht darin, dieses auf dem Halbleiterkörper in direktem Kontakt mit demselben oder beabstandet anzuordnen. Auf dem Winkelfilterelement kann ferner das Lumineszenzkonversionselement angeordnet sein. Vorzugsweise ist das Lumineszenzkonversionselement dem Winkelfilterelement in der Hauptabstrahlrichtung nachgeordnet.

Mit Vorteil ist das Winkelfilterelement bei dieser Anordnung geeignet dafür, sowohl rückseitig auftreffende Strahlung der ersten Wellenlänge als auch vorderseitig auftreffende Strahlung der zweiten Wellenlänge zu reflektieren. Somit kann das Winkelfilterelement Strahlung der zweiten Wellenlänge, die im Lumineszenzkonversionselement erzeugt und isotrop in alle Richtungen abgestrahlt wird, in Richtung einer Auskoppelseite des Lumineszenzdiodenchips reflektieren. Dadurch kann die Effizienz des Lumineszenzdiodenchips erhöht werden.

Gemäß einer bevorzugten Ausführungsform ist das Lumineszenzkonversionselement eine auf das Winkelfilterelement aufgebrachte Lumineszenzkonversionsschicht. Bei gleichmäßiger Dicke der Lumineszenzkonversionsschicht und omnidirektionaler Abstrahlung des Halbleiterkörpers wäre ohne Winkelfilterelement aufgrund der winkelabhängigen Weglänge ein erhöhter Anteil der Strahlung erster Wellenlänge in einer Richtung senkrecht zu einer Oberfläche des Halbleiterkörpers zu erwarten. Vorteilhafterweise kann die optische Wirkung des Winkelfilterelements an eine Gestalt des Lumineszenzkonversionselements angepasst werden, so dass das Lumineszenzkonversionselement grundsätzlich verschiedenartig geformt sein kann.

Gemäß einer weiter bevorzugten Ausführungsform ist das Lumineszenzkonversionselement ein Verguss, der zumindest einen Lumineszenzkonversionsstoff enthält und in welchen das Winkelfilterelement und der Halbleiterkörper eingebettet sind. Vorzugsweise ist der Lumineszenzkonversionsstoff in dem Verguss homogen verteilt.

Der Lumineszenzkonversionsstoff ist zur Wellenlängenkonversion zumindest eines Teils der von dem Halbleiterkörper emittierten Strahlung der ersten Wellenlänge zu größeren Wellenlängen hin, insbesondere der zweiten Wellenlänge, vorgesehen. Geeignete Lumineszenzkonversionsstoffe, wie zum Beispiel YAG:Ce, sind aus der WO 98/12757 bekannt, deren Inhalt hiermit insbesondere in Bezug auf Leuchtstoffe durch Referenz aufgenommen wird. Das Lumineszenzkonversionselement ist vorteilhaft eine Kunststoffschicht, bevorzugt eine Silikonschicht, in die der zumindest eine Lumineszenzkonversionsstoff matrixartig eingebettet ist. Das Lumineszenzkonversionselement ist vorteilhaft mit einem Siebdruckverfahren auf die Strahlungsaustrittsfläche des Halbleiterkörpers in Form einer Schicht aufgebracht.

Eine weitere Möglichkeit zur Anordnung des Winkelfilterelements besteht darin, dieses dem Lumineszenzkonversionselement nachzuordnen, wobei das Lumineszenzkonversionselement in direktem Kontakt oder beabstandet auf dem Halbleiterkörper angeordnet ist. Vorzugsweise ist das Winkelfilterelement dem Lumineszenzkonversionselement in der Hauptabstrahlrichtung nachgeordnet.

Gemäß einer bevorzugten Ausgestaltung ist das Winkelfilterelement ein dielektrischer Filter. Mit Vorteil sind Reflexions- und Transmissionseigenschaften des Winkelfilterelements, das dieelektrische Materialien enthält beziehungsweise ein dielektrischer Filter ist, durch Wahl der Materialien und Aufbau des Winkelfilterelements einstellbar.

Bevorzugterweise umfasst das Winkelfilterelement einen Schichtenstapel aus mindestens zwei Schichten mit verschiedenem Brechungsindex. Besonders bevorzugt alterniert der Brechungsindex bei mehr als zwei Schichten, das heißt, dass eine erste und eine dritte Schicht einen ersten Brechungsindex aufweisen, während eine zwischen der ersten und dritten Schicht angeordnete zweite Schicht einen zweiten Brechungsindex aufweist, der vom ersten Brechungsindex verschieden ist. Am Übergang zwischen zwei Schichten mit unterschiedlichem Brechungsindex wird ein Teil der Strahlung reflektiert und ein Teil der Strahlung transmittiert, der vorzugsweise dem nicht-reflektierten Strahlungsanteil entspricht, so dass kaum Verluste durch Absorption entstehen.

Für den dielektrischen Filter sind Silizium-haltige Materialien geeignet. Beispielsweise kann eine erste Schicht ein Siliziumoxid und eine zweite Schicht ein Siliziumnitrid enthalten. Ferner können auch Titan-haltige Materialien für den dielektrischen Filter verwendet werden. Beispielsweise kann eine erste Schicht ein Siliziumoxid und eine zweite Schicht ein Titanoxid enthalten.

Gemäß einer bevorzugten Variante ist das Winkelfilterelement ein Bragg-Spiegel. Hierbei weisen die Schichten, aus welchen der Bragg-Spiegel gebildet ist, eine geeignete Dicke auf, so dass Interferenzeffekte vorteilhaft genutzt werden. Bevorzugte Schichtdicken liegen im Bereich zwischen einem und drei Vierteln der ersten Wellenlänge, wobei unter der Wellenlänge diejenige Wellenlänge im jeweiligen Medium zu verstehen ist.

Weiterhin kommt als Winkelfilterelement jedes Element in Frage, das insbesondere für Lichtstrahlen der ersten Wellenänge für kleinere Einfallswinkel, welche mit der Hauptabstrahlrichtung den Winkel -30° ≤ θ ≤ 30° einschließen, einen erhöhten Reflexionsgrad und für größere Einfallswinkel, welche mit der Hauptabstrahlrichtung den Winkel 30° ≤ θ ≤ 60° oder -60° ≤ θ ≤ -30°einschließen, einen erhöhten Transmissionsgrad aufweist. Beispielsweise kann das Winkelfilterelement ein Element mit einer Oberflächenstruktur sein, die dazu geeignet ist, auftreffende Lichtstrahlen in Abhängigkeit von ihrem Einfallswinkel unterschiedlich stark zu reflektieren. Die Oberflächenstruktur kann aus einer Mehrzahl von Strukturelementen bestehen, die vorzugsweise regelmäßig auf einer Oberfläche des Winkelfilterelements angeordnet sind. Mögliche Formen für die Strukturelemente sind kegelartige, pyramidenartige oder prismenartige Voll- oder Hohlkörper.

Gemäß einer vorteilhaften Ausgestaltung befindet sich die Wellenlänge der in Richtung des Halbleiterkörpers zurückreflektierten Strahlung an einer langwelligen Flanke eines Stoppbandes des Winkelfilterelements. Dadurch reflektiert das Winkelfilterelement Lichtstrahlen, die mit einem relativ kleinen Einfallswinkel auf das Winkelfilterelement auftreffen, da sie noch im Stoppband liegen, während Lichtstrahlen mit größerem Einfallswinkel transmittiert werden.

Gemäß einer alternativen Ausgestaltung befindet sich die Wellenlänge der in Richtung des Halbleiterkörpers zurückreflektierten Strahlung innerhalb eines Stoppbandes des Winkelfilterelements. Auch hier werden Lichtstrahlen, die unter kleinen Einfallswinkeln auf das Winkelfilterelement auftreffen reflektiert, während Lichtstrahlen, die unter größeren Einfallswinkeln auf das Winkelfilterelement auftreffen, transmittiert werden.

Bei einer weiteren vorteilhaften Ausgestaltung ist der Halbleiterkörper ein Dünnfilm-Halbleiterkörper. Bei der Herstellung eines Dünnfilm-Halbleiterkörpers wird eine funktionelle Halbleiterschichtenfolge, die insbesondere eine strahlungsemittierende aktive Schicht umfasst, zunächst epitaktisch auf einem Aufwachssubstrat aufgewachsen, anschließend ein neuer Träger auf die dem Aufwachssubstrat gegenüber liegende Oberfläche der Halbleiterschichtenfolge aufgebracht und nachfolgend das Aufwachssubstrat abgetrennt. Da insbesondere die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wiederverwertbar ist. Das Ablösen eines Aufwachssubstrats aus Saphir von einer Halbleiterschichtenfolge aus einem Nitridverbindungshalbleiter kann beispielsweise mit einem aus der WO 98/14986 bekanntem Laser-Lift-Off-Verfahren erfolgen.

Ein Grundprinzip einer Dünnfilm-LED ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Insbesondere kann der Halbleiterkörper eine Epitaxie-Schichtenfolge aufweisen, die auf Nitridverbindungshalbleitern basiert. "Auf NitridVerbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₓGa_{y}In_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₓGa_{y}In_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Gemäß einer weiteren Ausgestaltung des Lumineszenzdiodenchips ist auf einer dem Winkelfilterelement abgewandten Seite des Halbleiterkörpers eine Reflexionsschicht angeordnet. Mittels der Reflexionsschicht, die auftreffende Strahlern vorzugsweise in Richtung des Halbleiterkörpers zurückreflektiert, wodurch wiederum Photonrecycling möglich ist, kann die Effizienz des Lumineszenzdiodenchips weiter gesteigert werden.

Ein erfindungsgemäßes Lumineszenzdioden-Bauelement weist einen Lumineszenzdiodenchip gemäß einem der beschriebenen Ausführungsbeispiele auf, wobei der Lumineszenzdiodenchip in einem Gehäuse angeordnet ist.

Weitere Merkmale, Vorteile und Weiterbildungen der Erfindung ergeben sich aus den nachfolgend in Verbindung mit den Figuren 1 bis 6 erläuterten Ausführungsbeispielen.

Es zeigen:
Figur 1A einen für einen Lumineszenzdiodenchip gemäß einer ersten Ausführungsform der Erfindung geeigneten Halbleiterchip und Figur 1B einen Lumineszenzdiodenchip gemäß einer ersten Ausführungsform der Erfindung,
Figur 2A einen herkömmlichen Halbleiterchip ohne Winkelfilterelement und Figur 2B einen herkömmlichen Lumineszenzdiodenchip ohne Winkelfilterelement,
Figur 3A ein Winkelfilterelement gemäß einer ersten bevorzugten Variante und Figur 3B ein Reflexionswinkelspektrum des in Figur 3A dargestellten Winkelfilterelements,
Figur 4A ein Winkelfilterelement gemäß einer zweiten bevorzugten Variante und Figur 4B ein Reflexionswinkelspektrum des in Figur 4A dargestellten Winkelfilterelements,
Figur 5A ein Winkelfilterelement gemäß einer dritten bevorzugten Variante, Figur 5B ein Reflexionswinkelspektrum des in Figur 5A dargestellten Winkelfilterelements und Figur 5C ein wellenlängenabhängiges Reflexionsspektrum des in Figur 5A dargestellten Winkelfilterelements,
Figur 6 einen Lumineszenzdiodenchip gemäß einer zweiten Ausführungsform der Erfindung.

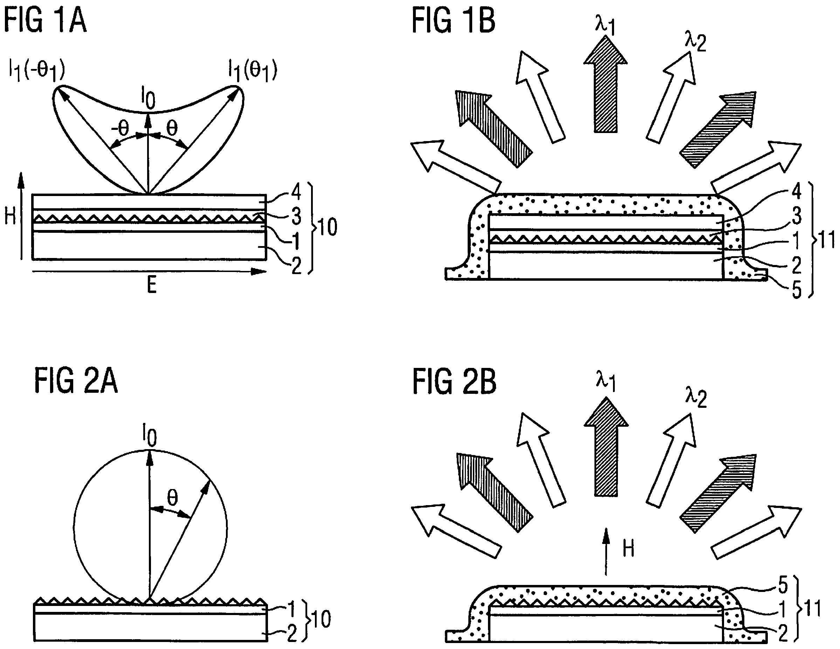

Der in Figur 1A dargestellte Halbleiterchip 10 weist einen Halbleiterkörper 1 und ein Winkelfilterelement 4 auf. Das Winkelfilterelement 4 ist dem Halbleiterkörper 1 in einer Hauptabstrahlrichtung H nachgeordnet. Die Hauptabstrahlrichtung H verläuft parallel zu einer Wachstumsrichtung, in welcher Schichten, die den Halbleiterkörper 1 bilden (nicht dargestellt), gewachsen sind. Ferner verläuft die Hauptabstrahlrichtung H senkrecht zu einer Haupterstreckungsebene E, welche durch zwei längste Kanten des Halbleiterchips 10 aufgespannt wird.

Der Halbleiterkörper 1 ist ein Dünnfilm-Halbleiterkörper mit Lambert'scher Abstrahlcharakteristik, was bedeutet, dass in der Hauptabstrahlrichtung H (θ = 0°) ein Intensitätsmaximum auftritt, wenn kein Winkelfilterelement vorhanden ist. Mit dem Winkelfilterelement 4 weist der Halbleiterchip 10 jedoch eine im Vergleich zur Lambert'schen Abstrahlcharakteristik gestauchte Abstrahlcharakteristik auf. So ist ein in der Hauptabstrahlrichtung H auftretender Intensitätswert I₀ kleiner als ein unter einem Winkel θ₁ beziehungsweise -θ₁ auftretender Intensitätswert I₁. Dies hat den Vorteil, dass ein wie in Figur 1B dargestellter Lumineszenzdiodenchip 11, der auf einer Auskoppelseite ein Lumineszenzkonversionselement 5 gleichmäßiger Dicke aufweist, die in der Hauptabstrahlrichtung H emittierte Strahlung gegenüber einem herkömmlichen Lumineszenzdiodenchip abgeschwächt ist (vgl. Figur 2B). Dies hat zur Folge, dass eine von dem Lumineszenzdiodenchip 11 emittierte Gesamtstrahlung einen einheitlichen Farbort in einem Winkelbereich [-θ,θ] aufweist, wobei sich der Winkelbereich vorzugsweise von -90° bis 90° erstreckt.

Der in Figur 1A dargestellte Halbleiterkörper 1 ist rückseitig mit einem von einem Aufwachssubstrat verschiedenen Träger 2 verbunden. Der Träger 2 enthält vorzugsweise ein Material mit hoher thermischer Leitfähigkeit, beispielsweise ein Si-haltiges Material wie SiC. Ferner kann eine hohe elektrische Leitfähigkeit des Trägers 2 von Vorteil sein, so dass ein rückseitiger elektrischer Anschluss des Halbleiterchips 10 mittels des Trägers 2 möglich ist.

Der Halbleiterkörper 1 ist vorderseitig aufgeraut. Die aufgeraute Oberfläche ermöglicht gegenüber einer flachen Oberfläche eine bessere Auskopplung der in einer aktiven Zone des Halbleiterkörpers 1 erzeugten Strahlung. Jedoch können sich Schichten von einer aufgerauten Oberfläche leichter ablösen als von einer ebenen Oberfläche. Daher ist der aufgeraute Halbleiterkörper 1 mit einer Planarisierungsschicht 3 versehen. Die Planarisierungsschicht 3 enthält vorzugsweise ein für die im Halbleiterkörper 1 erzeugte Strahlung durchlässiges Material. Beispielsweise kann für die Planarisierungsschicht 3 SiO₂ verwendet werden.

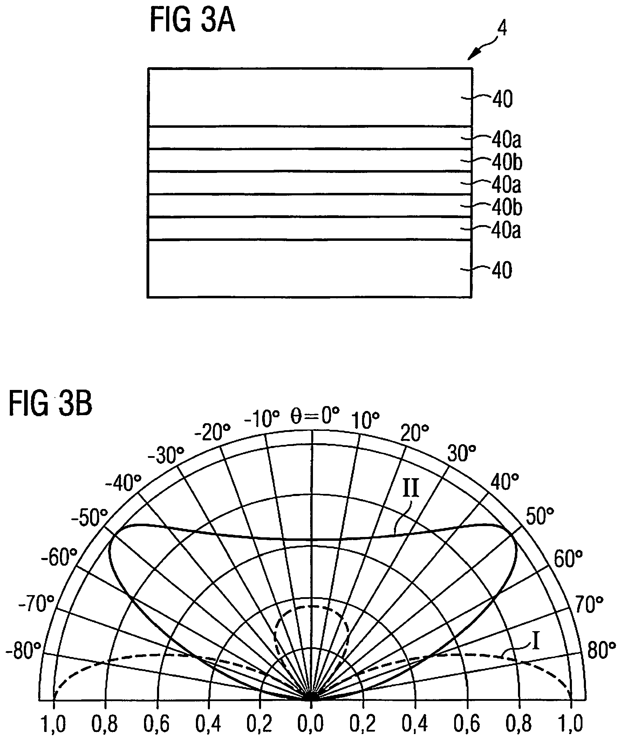

Das Winkelfilterelement 4 ist vorzugsweise ein dielektrischer Filter, der mehrere Schichten mit unterschiedlichem Brechungsindex aufweist. Die Schichten können nacheinander auf die Planarisierungsschicht 3 aufgebracht, beispielsweise aufgesputtert, werden. Alternativ kann ein separates, vorgefertigtes Winkelfilterelement 4 auf der Planarisierungsschicht 3 angeordnet werden. Mögliche Winkelfilterelemente sind im Zusammenhang mit den Figuren 3A, 4A und 5A beschrieben.
Der in Figur 1B dargestellte Lumineszenzdiodenchip 11 ist wie der in Figur 1A dargestellte Halbleiterchip 10 aufgebaut, weist aber zusätzlich das Lumineszenzkonversionselement 5 auf. Das Lumineszenzkonversionselement 5 ist ein Verguss, in welchen der restliche Halbleiterchip eingebettet ist. Der Verguss enthält Lumineszenzkonversionsstoffe zur Wellenlängenkonversion zumindest eines Teils der von dem Halbleiterkörper 1 emittierten Strahlung der ersten Wellenlänge λ₁ zu größeren Wellenlängen hin, insbesondere der zweiten Wellenlänge λ₂. Wie durch Pfeile angedeutet ist, ist die in der Hauptabstrahlrichtung H emittierte Strahlung erster Wellenlänge λ₁ gleich intensiv wie die unter anderen Winkeln abgegebene Strahlung.

Im Gegensatz hierzu ist bei einem herkömmlichen Chip 10 ohne Winkelfilterelement, wie in Figur 2A dargestellt, die Intensität der Strahlung in der Hauptabstrahlrichtung H maximal, was bei einem herkömmlichen Lumineszenzdiodenchip 10 mit dem Lumineszenzkonversionselement 5 dazu führt, dass die Strahlung erster Wellenlänge λ₁ ebenfalls ein Intensitätsmaximum in der Hauptabstrahlrichtung H aufweist. Dieser Effekt wird noch dadurch verstärkt, dass ein optischer Weg durch das Lumineszenzkonversionselement 5 in der Hauptabstrahlrichtung am kürzesten ist. Dies hat zur Folge, dass in der Hauptabstrahlrichtung H weniger Strahlung der ersten Wellenlängen λ₁ in Strahlung der zweiten Wellenlänge λ₂ konvertiert wird.

Figur 3A zeigt eine erste bevorzugte Variante eines Winkelfilterelementes 4. Dieses ist ein dielektrischer Mehrschichtfilter. Das Winkelfilterelement 4 weist eine Mehrzahl von Schichten auf, die sich durch Material oder Schichtdicke voneinander unterscheiden. Insbesondere können die Schichten 40a und 40b eine Schichtdicke aufweisen, die λ₁/4n beträgt, wobei n der Brechungsindex eines jeweiligen Schichtmaterials ist. Geeignete Materialien sind für die Schichten 40 und 40b SiO₂ mit einem Brechungsindex n₁ = 1.5 und für die Schichten 40a SiN mit einem Brechungsindex n₂ = 2.0. Der Brechungsindex n ändert sich innerhalb des Winkelfilterelements 4 periodisch. Das Winkelfilterelement 4 besteht aus drei Perioden eines SiO₂/SiN-Bragg-Spiegels.

Jedoch ist das Winkelfilterelement 4 nicht auf diese Anzahl von Perioden beschränkt. Vielmehr ist die Anzahl der Schichten abhängig von einer gewünschten Charakteristik des Reflexionswinkelspektrums.

Das in Figur 3A dargestellte Winkelfilterelement 4 ist auf eine Designwellenlänge λ_{D} abgestimmt, die kleiner ist als die Wellenlänge λ₁ der von dem Halbleiterkörper erzeugten Strahlung. Mit anderen Worten liegt die Designwellenlänge λ_{D} innerhalb eines Passbandes des Winkelfilterelements 4. Ferner ist das Winkelfilterelement 4 gegenüber der Wellenlänge λ₁ verstimmt oder anders ausgedrückt liegt die Wellenlänge λ₁ an einer langwelligen Flanke eines Stoppbandes des Winkelfilterelements 4. Dadurch reflektiert das Winkelfilterelement 4 Lichtstrahlen, die unter kleineren Einfallswinkeln auf das Winkelfilterelement 4 auftreffen, während Lichtstrahlen, die unter größeren Einfallswinkeln auf das Winkelfilterelement 4 auftreffen, transmittiert werden. Insbesondere beträgt die Wellenlänge λ₁ etwa 460nm, während die Designwellenlänge λ_{D} etwa 400nm beträgt.

Das Schaubild gemäß Figur 3B zeigt das Reflexionswinkelspektrum des in Figur 3A dargestellten Winkelfilterelements 4. Die gestrichelte Kurve I stellt einen Intensitätsreflexionsfaktor für alle Winkel θ graphisch dar, wobei -90° ≤ θ ≤ 90° ist. Die durchgezogene Kurve II stellt einen Intensitätstransmissionsfaktor für denselben Winkelbereich graphisch dar. Wie aus Figur 3B hervorgeht, ist die Transmission in der Hauptabstrahlrichtung, also bei dem Winkel θ = 0°, deutlich abgeschwächt beziehungsweise die Reflektivität deutlich erhöht. Dieses Verhalten kehrt sich in einem Winkelbereich von etwa 30° ≤ θ ≤ 60° beziehungsweise-60° ≤ θ ≤ -30° um.

Lichtstrahlen, die unter kleineren Einfallswinkeln auf das Winkelfilterelement 4 auftreffen, das heißt mit der Hauptabstrahlrichtung den Winkel -30° ≤ θ ≤ 30° einschließen, werden zu etwa 40% reflektiert, während Lichtstrahlen, die unter größeren Einfallswinkeln auf das Winkelfilterelement 4 auftreffen, das heißt mit der Hauptabstrahlrichtung den Winkel 30° ≤ θ ≤ 60° beziehungsweise -60° ≤ θ ≤ -30° einschließen, zu 80% bis 100% transmittiert werden.

Bei diesem Ausführungsbeispiel gilt für den vorgegebenen Winkelbereich [-30°, 30°].

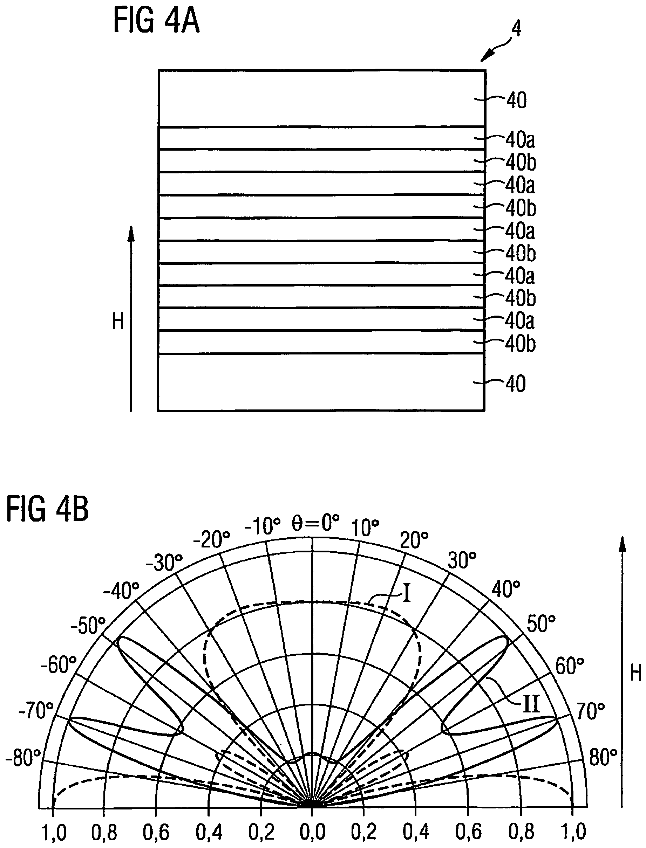

Ein weiteres Ausführungsbeispiel eines Winkelfilterelements 4 ist in Figur 4A gezeigt. Auch dieses Winkelfilterelement 4 ist ein dielektrischer Mehrschichtfilter. Die Schichten des Winkelfilterelements 4 sind derart angeordnet; dass ein erster Brechungsindex n₁ und ein zweiter Brechungsindex n₂ periodisch wiederkehren. Insgesamt weist das Winkelfilterelement 4 fünf derartige Perioden zwischen den beiden Schichten 40 auf. Vorzugsweise enthalten die Schichten 40 und 40b ein Material mit dem gleichen Brechungsindex n₁, während die Schichten 40a ein Material mit dem Brechungsindex n₂ aufweisen. Insbesondere gilt n₂ > n₁. Beispielsweise können der Brechungsindex n₁ = 1.5 und der Brechungsindex n₂ = 2.0 sein. Geeignete Materialien sind für die Schichten 40 und 40b SiO₂ und für die Schichten 40a SiN.

Die Schichtdicke beträgt insbesondere für die Schichten 40a λ₁/4n₂ und 40b λ₁/4n₁. Vorteilhafterweise können dadurch Lichtstrahlen, die in der Hauptabstrählungsrichtung H auf das Winkelfilterelement 4 auftreffen und an Übergängen zwischen den Schichten 40a und 40b reflektiert werden, konstruktiv interferieren. Denn der Gangunterschied zwischen zwei reflektierten Lichtstrahlen ist Δϕ = 0, wobei der erste Lichtstrahl an einem ersten Übergang Schicht 40b/Schicht 40a und der zweite Lichtstrahl an einem nachgeordneten zweiten Übergang Schicht 40a/Schicht 40b reflektiert wird. Dies ist dadurch gegeben, dass an dem ersten Übergang aufgrund der Reflexion am optisch dichteren Medium ein Phasensprung von n auftritt, welcher der Phasenverschiebung aufgrund eines längeren Weges des zweiten Lichtstrahls durch die Schicht 40a entspricht, die ebenfalls n beträgt.

Das Winkelfilterelement 4 ist auf die Wellenlänge λ₁ abgestimmt, was bedeutet, dass die Wellenlänge λ₁ nicht wie bei dem Winkelfilterelement gemäß Figur 3A an einer Flanke des Stoppbandes, sondern innerhalb des Stoppbandes liegt. Wie in Figur 4B dargestellt, weist das Winkelfilterelement 4 für kleinere Einfallswinkel ein hohes Reflexionsvermögen (vgl. Kurve I) und für größere Einfallswinkel ein geringes Reflexionsvermögen (vgl. Kurve II) auf.

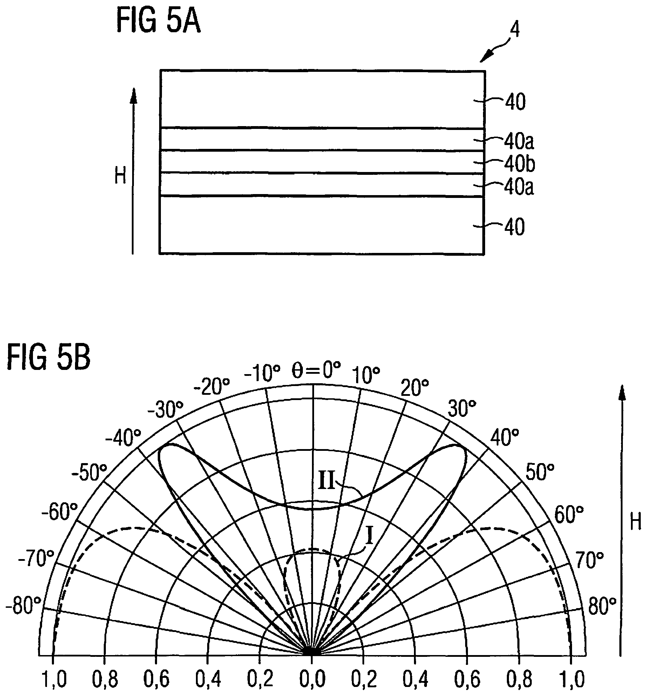

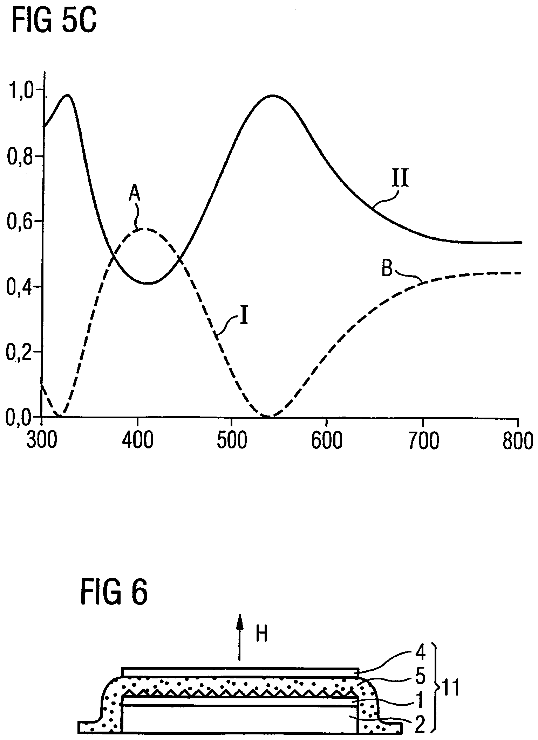

Das in Figur 5A dargestellte Winkelfilterelement 4, bei dem es sich um einen verstimmten Resonator handelt, ist insbesondere für einen wie in Figur 1B gestalteten Lumineszenzdiodenchip 11 geeignet, bei welchem das Lumineszenzkonversionselement 5 dem Winkelfilterelement 4 nachgeordnet ist. Denn das Winkelfilterelement 4 weist nicht nur für die Strahlung der ersten Wellenlänge λ₁, die hier vorzugsweise im blauen Spektralbereich liegt, einen hohen Reflexionsgrad auf, sondern auch für die Strahlung der zweiten Wellenlänge λ₂, die hier vorzugsweise im gelben Spektralbereich liegt. Wie aus dem in Figur 5C dargestellten Schaubild hervorgeht, in welchem der Intensitätsreflexionsfaktor (vgl. Kurve I) beziehungsweise der Intensitätstransmissionsfaktor (vgl. Kurve II) gegenüber der Wellenlänge [nm] aufgetragen ist, weist die Kurve I im blauen Spektralbereich einen Peak A und im gelben Spektralbereich einen Peak B auf. Vorteilhafterweise kann somit die Strahlung, die von dem Lumineszenzkonversionselement 5 (vgl. Figur 1B) in Richtung des Winkelfilterelements 4 emittiert wird, mittels des Winkelfilterelements 4 in Richtung einer Auskoppelseite des Lumineszenzdiodenchips reflektiert werden.

Das Winkelfilterelement 4 weist eine wie in Figur 5A gezeigte Schichtenfolge auf, welche die Schichten 40 und 40b mit einem ersten identischen Brechungsindex λ₁ und die Schichten 40a mit einem zweiten Brechungsindex n₂, der größer ist als der erste Brechungsindex n₁, umfasst. Insbesondere enthalten die Schichten 40 und 40b SiO₂ mit dem Brecheungsindex n₁ = 1.5, während die Schichten 40a TiO₂ mit dem Brechungsindex n₂ = 2.0 aufweisen. Geeignete Schichtdicken sind für die Schichten 40a λ₁/4n₂ und für die Schicht 40b 5λ₁/8n₁.

Das Reflexionswinkelspektrum des Winkelfilterelements 4 gemäß Figur 5A ist in Figur 5B dargestellt. Wie in den vorausgehenden Ausführungsbeispielen ist auch hier der Intensitätsreflexionsfaktor (vgl. Kurve I) für kleinere Einfallswinkel höher als für größere Einfallswinkel. Daraus resultiert ein Intensitätstransmissionsspektrum (vgl. Kurve II) und eine damit verbundene Abstrahlcharakteristik, die im Vergleich zur Lambert'schen Abstrahlcharakteristik im Bereich kleinerer Einfallswinkel gestaucht ist.

Figur 6 zeigt ein weiteres Ausführungsbeispiel eines Lumineszenzdiodenchips 11. Hierbei ist das Winkelfilterelement 4 dem Lumineszenzkonversionselement 5 in der Hauptabstrahlrichtung H nachgeordnet. Somit kann bereits im Lumineszenzkonversionselement 5 Photonrecycling stattfinden. Denn die vom Winkelfilterelement 4 in Richtung des Halbleiterkörpers 1 zurückreflektierte Strahlung kann in dem Lumineszenzkonversionselement 5 absorbiert und reemittiert werden, bevor die zurückreflektierte Strahlung in den Halbleiterkörper 1 gelangt. Typischerweise wird die im Lumineszenzkonversionselement 5 absorbierte Strahlung mit größerer Wellenlänge λ₂ reemittiert. Wenn das Winkelfilterelement 4 nur für Strahlung der Wellenlänge λ₁ ein erhöhtes Reflexionsvermögen zeigt, so weist der Lumineszenzdiodenchip 11 gemäß Figur 6 gegenüber dem in Figur 1B dargestellten Lumineszenzdiodenchip 11 einen erhöhten Anteil der Strahlung λ₂ in der Gesamtstrahlung auf.

Die Erfindung ist nicht durch die Beschreibung anhand der Ausführungsbeispiele beschränkt. Vielmehr ist die Erfindung durch die folgenden Patentansprüche definiert.

## Patentansprüche

1. Lumineszenzdiodenchip (11) mit
- einem Halbleiterkörper (1), der Strahlung einer ersten Wellenlänge (λ₁) erzeugt,
- einem Lumineszenzkonversionselement (5), das aus der Strahlung erster Wellenlänge (λ₁) Strahlung einer zweiten Wellenlänge (λ₂) erzeugt, und
- einem Winkelfilterelement (4), das Strahlung, die in einem vorgegebenen Winkelbereich relativ zu einer Hauptabstrahlrichtung (H) auf das Winkelfilterelement (4) auftrifft, zumindest teilweise in Richtung des Halbleiterkörpers (1) zurückreflektiert,
**dadurch gekennzeichnet, dass**
das Winkelfilterelement (4) für kleine Einfallswinkel, welche mit der Hauptabstrahlrichtung den Winkel -30° ≤ θ ≤ 30° einschließen, ein höheres Reflexionsvermögen und für größere Einfallswinkel, welche mit der Hauptabstrahlrichtung den Winkel 30° ≤ θ ≤ 60° oder -60° ≤ θ ≤ -30°einschließen, ein geringeres Reflexionsvermögen für Lichtstrahlen der ersten Wellenlänge (λ₁) aufweist.

2. Lumineszenzdiodenchip (11) nach Anspruch 1, wobei die Lichtstrahlen der ersten Wellenlänge (λ₁), die unter Einfallswinkeln von -30° ≤ θ ≤ 30° auf das Winkelfilterelement (4) auftreffen, zu etwa 40% reflektiert werden, während Lichtstrahlen, die unter Einfallswinkeln von 30° ≤ θ ≤ 60° auf das Winkelfilterelement (4) auftreffen, zu 80% bis 100% transmittiert werden,
wobei eine Designwellenlänge (λ_{D}) des Winkelfilterelements (4) kleiner ist als die Wellenlänge (λ₁) der von dem Halbleiterkörper (1) erzeugten Strahlung.

3. Lumineszenzdiodenchip (11) nach Anspruch 2, wobei die von dem Lumineszenzdiodenchip (11) abgegebene Gesamtstrahlung Strahlungsanteile der ersten Wellenlänge (λ₁) und der zweiten Wellenlänge (λ₂) aufweist.

4. Lumineszenzdiodenchip (11) nach einem der vorhergehenden Ansprüche, wobei
das Winkelfilterelement (4) Strahlung der ersten Wellenlänge (λ₁) in Richtung des Halbleiterkörpers (1) zurückreflektiert.

5. Lumineszenzdiodenchip (11) nach einem der vorhergehenden Ansprüche, wobei
das Winkelfilterelement (4) auf dem Halbleiterkörper (1) angeordnet ist und das Lumineszenzkonversionselement (5) dem Winkelfilterelement (4) in der Hauptabstrahlrichtung (H) nachgeordnet ist.

6. Lumineszenzdiodenchip (11) nach einem der vorhergehenden Ansprüche, wobei
das Winkelfilterelement (4) Strahlung der zweiten Wellenlänge (λ₂) in Richtung einer Auskoppelseite des Lumineszenzdiodenchips (11) reflektiert.

7. Lumineszenzdiodenchip (11) nach Anspruch 5 oder 6, wobei das Lumineszenzkonversionselement (5) eine auf das Winkelfilterelement (4) aufgebrachte Lumineszenzkonversionsschicht ist.

8. Lumineszenzdiodenchip (11) nach Anspruch 7, wobei das Lumineszenzkonversionselement (5) ein Verguss ist, der einen Lumineszenzkonversionsstoff enthält und in welchen das Winkelfilterelement (4) und der Halbleiterkörper (11) eingebettet sind.

9. Lumineszenzdiodenchip (11) nach einem der Ansprüche 1 bis 4, wobei
das Lumineszenzkonversionselement (5) auf dem Halbleiterkörper (1) angeordnet ist und das Winkelfilterelement (4) dem Lumineszenzkonversionselement (5) in der Hauptabstrahlrichtung (H) nachgeordnet ist.

10. Lumineszenzdiodenchip (11) nach einem der vorhergehenden Ansprüche, wobei
das Winkelfilterelement (4) ein dielektrischer Filter ist.

11. Lumineszenzdiodenchip (11) nach einem der vorhergehenden Ansprüche, wobei
das Winkelfilterelement (4) einen Schichtenstapel aus mindestens zwei Schichten mit verschiedenem Brechungsindex umfasst.

12. Lumineszenzdiodenchip (11) nach einem der Ansprüche 10 oder 11, wobei
das Winkelfilterelement (4) ein Bragg-Spiegel ist.

13. Lumineszenzdiodenchip (11) nach einem der Ansprüche 1 bis 10, wobei
das Winkelfilterelement (4) Strukturelemente aufweist, die kegelartig, pyramidenartig, prismenartig oder gleich inversen CPCs ausgebildet sind.

14. Lumineszenzdiodenchip (11) nach einem der vorhergehenden Ansprüche, wobei
sich die Wellenlänge der in Richtung des Halbleiterkörpers (1) zurückreflektierten Strahlung an einer langwelligen Flanke eines Stoppbandes des Winkelfilterelements (4) befindet.

15. Lumineszenzdiodenchip (11) nach einem der Ansprüche 1 bis 13, wobei
sich die Wellenlänge der in Richtung des Halbleiterkörpers (1) zurückreflektierten Strahlung innerhalb eines Stoppbandes des Winkelfilterelements (4) befindet.

## Claims

1. Luminescent diode chip (11) comprising
- a semiconductor body (1), which produces radiation of a first wavelength (λ₁),
- a luminescence conversion element (5), which produces from the radiation of the first wavelength (λ₁) radiation of a second wavelength (λ₂), and
- an angular filter element (4), which reflects radiation that impinges on the angular filter element (4) in a predetermined angular range in relation to a main direction of emission (H) at least partially back in the direction of the semiconductor body (1) **characterized in that**
- the angular filter element (4) has a higher reflectivity for light rays of the first wavelength (λ₁) for smaller angles of incidence, which include an angle of -30° ≤ 60° ≤ 30° with the the main direction of emission, and a lower reflectivity for light rays of the first wavelength (λ₁) for greater angles of incidence, which indlude an angle of 30° ≤ θ ≤ 60° or-60° ≤ θ ≤ -30°

2. Luminescent diode chip (11) according to Claim 1, wherein approximately 40% of light rays of a first wavelength (λ₁) that impinge on the angular filter element (4) at angles of incidence form an included angle of -30° ≤ 60° ≤ 30° are reflected, whereas 80% to 100% of light rays that impinge on the angular filter element at angles of incidence form an included angle of 60° ≤ θ ≤ 60° are transmitted, wherein a design wavelength (λ_{D}) of the angular filter element (4) is smaller than the first wavelength (λ₁), which is produced by the semiconductor body (1).

3. Luminescent diode chip (11) according to Claim 2, the overall radiation emitted by the luminescent diode chip (11) having radiation components of the first wavelength (λ₁) and of the second wavelength (λ₂).

4. Luminescent diode chip (11) according to one of the preceding claims, the angular filter element (4) reflecting radiation of the first wavelength (λ₁) back in the direction of the semiconductor body (1).

5. Luminescent diode chip (11) according to one of the preceding claims, the angular filter element (4) being arranged on the semiconductor body (1) and the luminescence conversion element (5) being arranged downstream of the angular filter element (4) in the main direction of emission (H).

6. Luminescent diode chip (11) according to one of the preceding claims, the angular filter element (4) reflecting radiation of the second wavelength (λ₂) in the direction of a coupling-out side of the luminescent diode chip (11).

7. Luminescent diode chip (11) according to Claim 5 or 6, the luminescence conversion element (5) being a luminescence conversion layer applied to the angular filter element (4).

8. Luminescent diode chip (11) according to Claim 7, the luminescence conversion element (5) being a sealing, which contains a luminescence conversion material and in which the angular filter element (4) and the semiconductor body (11) are embedded.

9. Luminescent diode chip (11) according to one of Claims 1 to 4, the luminescence conversion element (5) being arranged on the semiconductor body (1) and the angular filter element (4) being arranged downstream of the luminescence conversion element (5) in the main direction of emission (H).

10. Luminescent diode chip (11) according to one of the preceding claims, the angular filter element (4) being a dielectric filter.

11. Luminescent diode chip (11) according to one of the preceding claims, the angular filter element (4) comprising a stack of layers made up of at least two layers with different refractive indexes.

12. Luminescent diode chip (11) according to one of Claims 10 or 11, the angular filter element (4) being a Bragg reflector.

13. Luminescent diode chip (11) according to one of Claims 1 to 10, the angular filter element (4) having structural elements7 the structural elements being formed in a conical, pyramidal or prismatic manner or in a manner similar to inverse CPCs.

14. Luminescent diode chip (11) according to one of the preceding claims, the wavelength of the radiation reflected back in the direction of the semiconductor body (1) being at a long-wave flank of a stop band of the angular filter element (4).

15. Luminescent diode chip (11) according to one of Claims 1 to 13, the wavelength of the radiation reflected back in the direction of the semiconductor body (1) being within a stop band of the angular filter element (4).

## Revendications

1. Puce à diode électroluminescente (11) avec
- un corps semi-conducteur (1) qui génère un rayonnement d'une première longueur d'ondes (λ₁) ;
- un élément de conversion de la luminescence (5) qui génère un rayonnement d'une deuxième longueur d'ondes (λ₂) à partir du rayonnement de la première longueur d'ondes (λ₁) ; et
- un élément d'angle filtrant (4) qui réfléchit en retour, tout au moins en partie, un rayonnement dans la direction du corps semi-conducteur (1), lequel rayonnement arrive sur l'élément d'angle filtrant (4) dans une plage angulaire prédéterminée par rapport à une direction de rayonnement principale (H),
**caractérisée en ce que**
l'élément d'angle filtrant (4) présente un pouvoir réfléchissant plus élevé pour de faibles angles d'incidence, lesquels incluent l'angle -30° ≤ θ ≤ 30° avec la direction de rayonnement principale, et présente un pouvoir réfléchissant plus faible pour des angles d'incidence plus importants, lesquels incluent l'angle 30° ≤ 9 ≤ 60° ou l'angle -60° ≤ θ ≤ -30° avec la direction de rayonnement principale, pour des rayons lumineux de la première longueur d'ondes (λ₁).

2. Puce à diode électroluminescente (11) selon la revendication 1, où les rayons lumineux de la première longueur d'ondes (λ₁) qui arrivent sur l'élément d'angle filtrant (4) dans des angles d'incidence de -30° ≤ θ ≤ 30° sont réfléchis à environ 40 %, tandis que les rayons lumineux qui arrivent sur l'élément d'angle filtrant (4) dans des angles d'incidence de 30° ≤ θ ≤ 60° sont transmis dans une proportion comprise entre 80 % et 100 %,
où une longueur d'onde de calcul (λ_{D}) de l'élément d'angle filtrant (4) est inférieure à la longueur d'ondes (λ₁) du rayonnement généré par le corps semi-conducteur (1).

3. Puce à diode électroluminescente (11) selon la revendication 2, où le rayonnement total émis par la puce à diode électroluminescente (11) présente des proportions de rayonnement de la première longueur d'ondes (λ₁) et de la deuxième longueur d'ondes (λ₂).

4. Puce à diode électroluminescente (11) selon l'une des revendications précédentes, où
l'élément d'angle filtrant (4) réfléchit en retour le rayonnement de la première longueur d'ondes (λ₁) dans la direction du corps semi-conducteur (1).

5. Puce à diode électroluminescente (11) selon l'une des revendications précédentes, où
l'élément d'angle filtrant (4) est disposé sur le corps semi-conducteur (1) et l'élément de conversion de la luminescence (5) est disposé dans la direction de rayonnement principale (H), en aval de l'élément d'angle filtrant (4).

6. Puce à diode électroluminescente (11) selon l'une des revendications précédentes, où
l'élément d'angle filtrant (4) réfléchit le rayonnement de la deuxième longueur d'ondes (λ₂) dans la direction d'une face de déclenchement de la puce à diode électroluminescente (11).

7. Puce à diode électroluminescente (11) selon la revendication 5 ou 6, où l'élément de conversion de la luminescence (5) est une couche de conversion de la luminescence appliquée sur l'élément d'angle filtrant (4).

8. Puce à diode électroluminescente (11) selon la revendication 7, où l'élément de conversion de la luminescence (5) est un enrobage qui contient une substance de conversion de la luminescence et dans laquelle sont intégrés l'élément d'angle filtrant (4) et le corps semi-conducteur (11).

9. Puce à diode électroluminescente (11) selon l'une des revendications 1 à 4, où
l'élément de conversion de la luminescence (5) est disposé sur le corps semi-conducteur (1) et l'élément d'angle filtrant (4) est disposé dans la direction de rayonnement principale (H), en aval de l'élément de conversion de la luminescence (5).

10. Puce à diode électroluminescente (11) selon l'une des revendications précédentes, où
l'élément d'angle filtrant (4) est un filtre diélectrique.

11. Puce à diode électroluminescente (11) selon l'une des revendications précédentes, où
l'élément d'angle filtrant (4) comprend une pile de couches constituées d'au moins deux couches comprenant divers indices de réfraction.

12. Puce à diode électroluminescente (11) selon l'une des revendications 10 ou 11, où
l'élément d'angle filtrant (4) est un réflecteur de Bragg.

13. Puce à diode électroluminescente (11) selon l'une des revendications 1 à 10, où
l'élément d'angle filtrant (4) présente des éléments de structure qui sont conçus en forme de cônes, en forme de pyramides, en forme de prismes ou similaires à des CPC inverses.

14. Puce à diode électroluminescente (11) selon l'une des revendications précédentes, où
la longueur d'ondes du rayonnement réfléchi en retour dans la direction du corps semi-conducteur (1) se trouve au niveau d'un flanc à onde longue d'une bande de rejet de l'élément d'angle filtrant (4).

15. Puce à diode électroluminescente (11) selon l'une des revendications 1 à 13, où
la longueur d'ondes du rayonnement réfléchi en retour dans la direction du corps semi-conducteur (1) se trouve à l'intérieur d'une bande de rejet de l'élément d'angle filtrant (4).
